# FASCICULE DE BREVET EUROPEEN

(11) **EP 0 881 872 B1**
(45) Date de publication et mention de la délivrance du brevet: **20.08.2003**
(21) Numéro de dépôt: 98201747.7
(22) Date de dépôt: 26.05.1998
(51) Int. Cl.: H05K 9/00

(54) **Ecran de blindage électromagnétique et support de circuit équipé d'un tel écran**
Elektronische Abschirmung und Leiterplatte mit einer solchen Abschirmung
Electromagnetic shielding screen and circuit support having such a screen

(30) Priorité: 29.05.1997 FR 9706582
(43) Date de publication de la demande: 02.12.1998
(73) Titulaire: Koninklijke Philips Electronics N.V., 5621 BA Eindhoven (NL)
(72) Inventeur: Venant, Sylvain, 75008 Paris (FR)
(74) Mandataire: Landousy, Christian

(56) Documents cités:
- EP-A- 0 661 154
- WO-A-96/06520
- US-A- 5 604 668
- PATENT ABSTRACTS OF JAPAN vol. 095, no. 011, 26 décembre 1995 & JP 07 221482 A (MATSUSHITA ELECTRIC IND CO LTD), 18 août 1995
- PATENT ABSTRACTS OF JAPAN vol. 095, no. 001, 28 février 1995 & JP 06 283884 A (NIPPON CHEMICON CORP), 7 octobre 1994

## Description

La présente invention concerne un écran de blindage électromagnétique comprenant une ceinture et au moins un couvercle prévu pour la coiffer, la ceinture et le couvercle, réalisés au moins en partie en un matériau électriquement conducteur, formant un sous-ensemble prévu pour être appliqué contre le support du circuit à blinder, la fixation du couvercle sur la ceinture étant assurée par le fait que la forme du ou des couvercles correspond à celle de la ceinture et que l'un et l'autre comprennent des surfaces en regard pour fixation par collage de l'une contre l'autre à l'aide d'une substance adhésive conductrice appliquée contre lesdites surfaces. Un tel écran de blindage est prévu pour être mis en place contre une carte de circuit imprimé ou contre tout autre support similaire de circuit électronique, par exemple dans un appareil téléphonique portable.

Un exemple d'association d'une carte de circuit imprimé et d'un écran de blindage électromagnétique est décrit dans la demande de brevet européen EP-A-0594041. Selon la structure indiquée dans ce document et illustrée sur la figure 1, l'écran de blindage est constitué d'une ceinture 11 et d'un couvercle coiffant celle-ci, qui forment l'un avec l'autre un sous-ensemble prévu pour être appliqué contre la carte de circuit imprimé 12 (ou autre support du circuit à blinder). Ce sous-ensemble est réalisé au moins en partie en un matériau électriquement conducteur afin de réaliser, pour la protection du circuit, une sorte de cage de Faraday. La réalisation du blindage en deux pièces distinctes permet éventuellement d'avoir accès aux circuits protégés, par ouverture du couvercle.

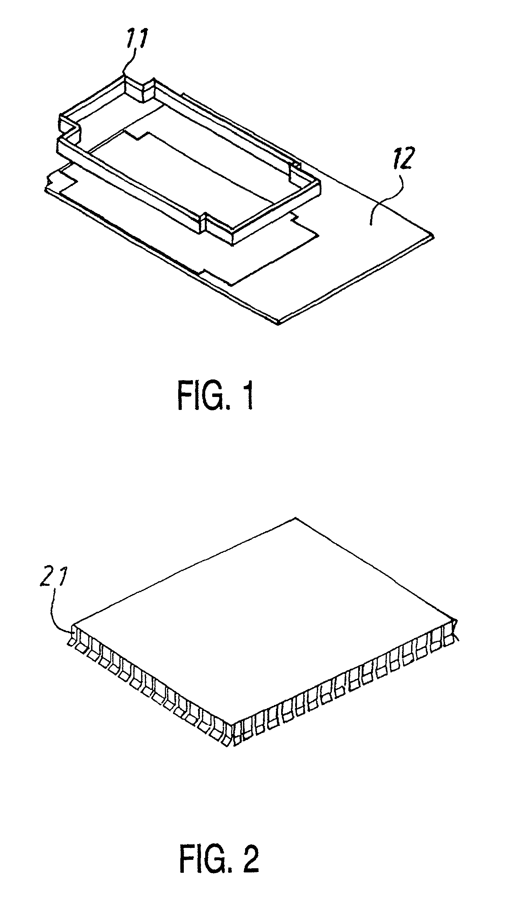

Les modes de liaison habituellement rencontrés pour la fixation du couvercle sur la ceinture sont la soudure, auquel cas la liaison est irréversible ou, du moins, implique des manipulations matérielles assez lourdes (dessouder/ressouder un couvercle), ou bien l'utilisation de solutions du genre lames ou rebords formant ressort et venant s'enclencher sur la ceinture. Ce genre de liaison, représenté par exemple sur la figure 2 qui illustre une liaison par éléments 21 formant ressort, est cette fois facilement démontable, mais les essais effectués montrent que des secousses ou des chocs exercés sur des structures ainsi réalisées conduisent souvent à l'ouverture intempestive du couvercle.

Un but de l'invention est donc de proposer un écran de blindage démontable dont la tenue aux chocs ou secousses soit bien meilleure que celle obtenue avec les réalisations antérieures.

A cet effet l'invention concerne un écran de blindage électromagnétique tel que défini dans le préambule de la description et qui est en outre caractérisé en ce que la substance adhésive est une matière qu conserve sa propriété adhésive même après décollage du ou des couvercles un nombre important de fois, en vue d'un recollage à la suite de chaque décollage. Les essais effectués avec ce genre de structure confirment la fiabilité mécanique de la solution proposée.

Cette solution reste applicable même lorsque la ceinture de l'écran de blindage délimite plusieurs compartiments distincts. Dans ce cas, chacun des compartiments pour lesquels il est souhaitable de pouvoir accéder au circuit protégé par le blindage est coiffé d'un couvercle dont la forme correspond à celle du compartiment associé, et chaque compartiment et le couvercle associé comprennent deux surfaces en regard pour fixation par collage de l'une de ces surfaces contre l'autre. Bien entendu, l'invention concerne l'une ou l'autre de ces structures d'écran de blindage, mais aussi toute carte de circuit imprimé ou tout autre support similaire de circuit électronique qui est équipé(e), pour la protection de ce circuit, d'une telle structure.

Le document US 5604668 décrit certes un blindage électromagnétique pour circuit imprimé ou tout autre support de circuit électronique, applicable à un boîtier réalisé en un matériau électriquement conducteur et comprenant un ou plusieurs compartiments qui peuvent être coiffés d'un couvercle commun ou de couvercles individuels ayant, pour permettre leur collage sur le boîtier, des surfaces en regard de celle de ce boîtier. Ce document ne fait cependant aucune mention du fait que le matériau adhésif choisi est une substance qui, après décollage d'un couvercle, permet de recoller celui-ci un nombre important de fois grâce à son effet adhésif persistant, sans avoir à réappliquer une couche de cette substance adhésive, qui est restée en place, prête au re-emploi.

EP0629114 décrit la possibilité de coller un couvercle sur la ceinture d'un écran de blindage par une substance adhésive conductrice. Cependant ce document ne mentionne pas que ce matériau adhésif conserve sa propriété adhésive même après décollage du couvercle un nombre important de fois et que cette substance est appliquée contre les surfaces en regard du couvercle et de la ceinture.

Les particularités et avantages de l'invention apparaîtront maintenant de façon plus détaillée dans la description qui suit et dans les dessins annexés, donnés à titre d'exemples et dans lesquels :
- la figure 1 montre un exemple de ceinture d'écran de blindage selon l'état de la technique, mise en place contre la carte ou le support du circuit à protéger ;
- la figure 2 illustre un exemple de couvercle d'écran de blindage selon l'état de la technique, dans lequel des pattes permettent la fixation du couvercle contre des rebords correspondants de la ceinture ou de compartiments de celles-ci ;
- la figure 3 met en évidence la structure et le mode de liaison qui permettent d'obtenir entre la ceinture et son ou ses couvercles, conformément à l'invention, une meilleure tenue aux chocs ou aux secousses.

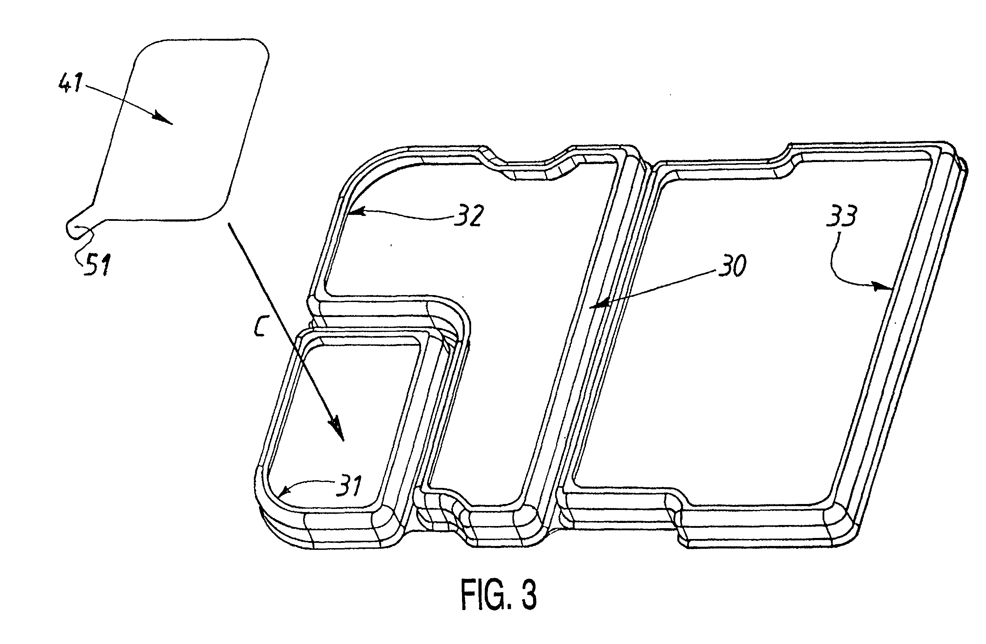

Conformément à l'invention, la structure maintenant proposée consiste, comme indiqué sur la figure 3, en une ceinture de blindage 30 ouverte à sa partie supérieure et comprenant, dans l'exemple représenté, trois compartiments 31, 32, 33. Cette ceinture 30 est réalisée au moins en partie en un matériau conducteur (magnésium ou aluminium) coulé, acier plié ou embouti, alliage Zamak,...). Aux compartiments de la ceinture 30 sont associés des couvercles de forme correspondante, dont un seul, le couvercle 41 pour le compartiment 31, est représenté. Ces couvercles, amovibles pour permettre l'accès à la zone délimitée à l'intérieur de la ceinture 30, sont également réalisés au moins en partie en un matériau conducteur (feuille d'aluminium, carton revêtu d'une couche métallique,...).

L'association de la ceinture et des couvercles (du couvercle lorsque la ceinture ne délimite qu'un seul et unique compartiment) constitue comme précédemment, pour la carte de circuit imprimé ou le support de circuit, une cage de Faraday, mais l'ouverture du ou d'un des couvercles de celle-ci est maintenant réalisable sans compromettre la tenue mécanique de l'ensemble ceinture/couvercle(s). En effet, chaque compartiment de la ceinture est délimité par une surface plane, une sorte de ruban suivant le contour dudit compartiment. Le couvercle associé, de forme correspondante, est plan et le bord de sa surface constitue une sorte de ruban prévu pour venir en regard de la surface correspondante du ruban suivant le contour du compartiment.

L'application d'une colle ou d'un adhésif contre ces deux surfaces en regard permet alors la fixation de ces deux éléments (ceinture et couvercle(s)) l'un contre l'autre, qui sont alors très fermement immobilisés, quels que soient les chocs ou secousses auxquels pourrait ensuite être soumis l'ensemble ceinture/couvercle(s) /support de circuit. Chaque couvercle comprend éventuellement une languette, 51 dans le cas du couvercle 41, pour faciliter l'ouverture de ce dernier. L'adhésif est une substance qui, après décollage du couvercle (à la manière de l'ouverture d'un pot de yaourt), permet cependant de recoller celui-ci, et ceci un nombre important de fois sans que cette substance perde son effet adhésif. Bien entendu, l'adhésif et la colle, quelle que soit la solution choisie, sont conducteurs (chargés en particules conductrices, d'argent ou de cuivre par exemple...) afin de préserver le contact électrique et la cage de Faraday ainsi constituée.

## Revendications

1. Ecran de blindage électromagnétique pour carte de circuit imprimé ou tout autre support similaire de circuit électronique, comprenant une ceinture (30) et au moins un couvercle (41) prévu pour la coiffer, la ceinture (30) et le ou les couvercles, réalisés au moins en partie en un matériau électriquement conducteur, formant un sous-ensemble prévu pour être appliqué contre le support du circuit à blinder, la fixation du couvercle sur la ceinture étant assurée par le fait que la forme du ou des couvercles correspond à celle de la ceinture et que l'un et l'autre comprennent des surfaces en regard pour fixation par collage de l'une contre l'autre à l'aide d'une substance adhésive conductrice **caractérisé en ce que** ladite substance est appliquée contre lesdites surfaces, ladite substance étant une matière qui conserve sa propriété adhésive même après décollage du ou des couvercles un nombre important de fois, en vue d'un recollage à la suite de chaque décollage.

2. Ecran de blindage selon la revendication 1, **caractérisé en ce que** chaque couvercle (41) est constitué d'une feuille d'aluminium et fixé contre le compartiment correspondant.

3. Carte de circuit imprimé ou autre support similaire de circuit électronique, **caractérisé(e) en ce qu'**il(elle) est équipé(e), pour la protection dudit circuit, d'un écran de blindage électromagnétique selon l'une des revendications 1 et 2.

## Patentansprüche

1. Elektronische Abschirmung für eine gedruckte Schaltung oder jeden anderen ähnlichen Träger einer elektronischen Schaltung, mit einer Umrandung (30) und mindestens einer zum Aufsetzen vorgesehenen Abdeckung (41), wobei die zumindest teilweise aus einem elektrisch leitenden Material gefertigte Umrandung (30) und die Abdeckung/en ein Teilsystem bilden, um auf die abzuschirmende Leiterplatte gebracht zu werden, die Befestigung der Abdeckung auf der Umrandung dank der Tatsache gewährleistet wird, dass die Form der Abdeckungen/en der der Umrandung entspricht und alle beide Flächen zur Befestigung durch Zusammenkleben mit Hilfe einer auf die besagten Flächen aufgetragenen leitenden Klebesubstanz aufweisen, **dadurch gekennzeichnet, dass** die besagte Substanz auf die besagten Flächen gebracht wird und die besagte Substanz ein Material ist, welches seine klebende Eigenschaft beibehält, selbst nachdem die Abdeckung/en ansehnliche Male abgelöst wurden, um sie nach jedem Ablösen wieder anzukleben.

2. Abschirmung nach Anspruch 1, **dadurch gekennzeichnet, dass** jede Abdeckung (41) aus einem Aluminiumblatt gebildet und an dem dementsprechenden Abteil befestigt wird.

3. Schaltungsleiterplatte oder beliebiger anderer Träger für elektronische Schaltung, **dadurch gekennzeichnet, dass** sie/er für den Schutz der besagten Schaltung mit einer elektronischen Abschirmung nach einem der Ansprüche 1 bis 2 ausgerüstet ist.

## Claims

1. An electromagnetic shielding screen for a printed circuit board or any other similar electronic circuit carrier comprising a band (30) and at least a cover (41) provided for covering the band, the band (30) and the cover or covers at least partly being made of an electrically conductive material forming a sub-assembly for being pressed against the carrier of the circuit to be shielded, the fastening of the cover to the band being ensured by the fact that the form of the cover or covers corresponds to that of the band and that they both comprise opposite surfaces for sticking them together by means of a conductive adhesive substance **characterized in that** said substance is applied to said surfaces, said substance being a material that retains its adhesive property even after the cover or covers has or have been removed a great number of times with a view to sticking again after the cover or covers has or have come off.

2. A shielding screen as claimed in claim 1, **characterized in that** each cover (41) is formed by an aluminum foil and fastened to the corresponding compartment.

3. A printed circuit board or other similar electronic circuit carrier, **characterized in that** it includes an electromagnetic shielding screen as claimed in one of the claims 1 to 2 for the protection of said circuit.
